# EUROPEAN PATENT APPLICATION

(11) **EP 4 467 689 A1**
(43) Date of publication of application: **27.11.2024**
(21) Application number: 23211524.6
(22) Date of filing: 22.11.2023
(51) Int. Cl.: C30B 29/06, H01L 31/0224, H01L 31/042, H01L 31/05, H01L 31/18, H01L 31/0352

(54) **METHOD FOR MANUFACTURING A SILICON WAFER, SOLAR CELL, AND PHOTOVOLTAIC MODULE**

(30) Priority: 23.05.2023 CN 202310588789; 23.05.2023 CN 202321305227 U; 23.05.2023 CN 202321296034 U; 23.05.2023 CN 202321282368 U
(71) Applicant: Zhejiang Jinko Solar Co., Ltd., Haining, Zhejiang 314416 (CN); JINKO SOLAR CO., LTD, ShangRao, Jiangxi 334100 (CN)
(72) Inventor: TAO, Wusong, ZHEJIANG, 314416 (CN); ZHANG, Rui, ZHEJIANG, 314416 (CN); XU, Tao, ZHEJIANG, 314416 (CN); LI, Tingting, ZHEJIANG, 314416 (CN); CHEN, Shuping, ZHEJIANG, 314416 (CN)
(74) Representative: DREISS Patentanwälte PartG mbB

(57) **Abstract**

Provided are a method for manufacturing a silicon wafer, a solar cell, and a photovoltaic module. The method includes: selecting four arc segments on a circumference of the silicon ingot according to chamfering parameters of the solar wafer; squaring the silicon ingot along lines connecting adjacent chamfered arc segments to obtain a rectangular body having a rectangular cross section with chamfers; and cutting the rectangular body along a direction perpendicular to a length direction of the silicon ingot to obtain a rectangular silicon wafer with chamfers.

## Description

### TECHNICAL FIELD

The present disclosure relates to the technical field of photovoltaic, and in particular, to a method for manufacturing a silicon wafer, a solar cell, and a photovoltaic module.

### BACKGROUND

With the development of technologies, a photovoltaic module has been widely used. A light-receiving area of a solar cell in the photovoltaic module is an important factor affecting efficiency of the photovoltaic module. The light-receiving area of the solar cell is mainly affected by a size of a silicon substrate of the solar cell, which is obtained from a silicon wafer. An area of the silicon wafer in the conventional photovoltaic module is small, and utilization of a silicon ingot is low, resulting in lower efficiency and higher costs of the photovoltaic module.

### SUMMARY

The present disclosure provides a method for manufacturing a silicon wafer, a solar cell, and a photovoltaic module.

According to one aspect, a method for manufacturing a silicon wafer is provided. The method includes: providing a silicon ingot having a circular cross section; selecting four arc segments on a circumference of the silicon ingot according to chamfering parameters of the silicon wafer; squaring the silicon ingot along lines connecting adjacent arc segments to obtain a rectangular body having a rectangular cross-section shape with chamfers; and cutting the rectangular body along a direction perpendicular to a length direction of the silicon ingot to obtain a rectangular silicon wafer with chamfers.

In some embodiments, the selecting four arc segments on a circumference of the silicon ingot according to chamfering parameters of the silicon wafer includes: selecting four arc segments each having an arc length ranging from 0.5 mm to 6 mm on the circumference of the silicon ingot, wherein circle centers of the four arc segments coincide with a center of the cross section of the silicon ingot.

In some embodiments, the selecting four arc segments on a circumference of the silicon ingot according to chamfering parameters of the silicon wafer includes: selecting four arc segments each having a central angles ranging from 0.3° to 3° on the circumference of the silicon ingot, wherein circle centers of the four arc segments coincide with a center of the cross section of the silicon ingot.

In some embodiments, the rectangular silicon wafer with chamfers has a width ranging from 182 mm to 188 mm.

In some embodiments, the rectangular silicon wafer with chamfers has a length ranging from 180 mm to 220 mm.

In some embodiments, the method further includes dividing the rectangular silicon wafer with chamfers into two symmetrical half-cut wafers along a straight line parallel to a width direction of the rectangular silicon wafer.

According to another aspect, a solar cell is provided. The solar cell includes a silicon substrate including four corners. The silicon substrate further includes four chamfer structures at the four corners of the silicon substrate respectively, each chamfer structure has an arc edge, and central angles of the arc edges of the four chamfer structures are equal. Or, the silicon substrate further includes two chamfer structures at two corners of the four corners of the silicon substrate respectively, the other two corners are right angles, each chamfer structure has an arc edge, and central angles of the arc edges of the two chamfer structures are equal.

In some embodiments, the solar cell has a length L1 ranging from 190 mm to 220 mm and a width W1 ranging from 177 mm to 187 mm, and the solar cell further includes N finger electrodes that are arranged along a length direction of the solar cell, and the quantity N of the finger electrodes satisfies 130<N<190. A central angle α corresponding to the arc edge of the chamfer structure satisfies 0.3°≤α≤3°.

In some embodiments, the length L1 of the solar cell satisfies 190 mm≤L1<200 mm, and the quantity N of the finger electrodes satisfies 145≤N≤165.

In some embodiments, the length L1 of the solar cell satisfies 200 mm≤L1≤220 mm, and the quantity N of the finger electrodes satisfies 160≤N≤180.

In some embodiments, along the length direction of the solar cell, a distance D1 between adjacent finger electrodes satisfies: 1 mm≤D1≤3 mm.

In some embodiments, the solar cell further includes M busbar electrodes. The M busbar electrodes are arranged along a width direction of the solar cell, the busbar electrodes intersect with the finger electrodes and are electrically connected to the finger electrodes, where the quantity M of the busbar electrodes satisfies 16≤M≤20.

In some embodiments, along the width direction of the solar cell, a distance D2 between adjacent busbar electrodes satisfies 9 mm≤D2≤12 mm.

In some embodiments, the solar cell further includes: finger electrodes extending along a width direction of the solar cell; busbar electrodes extending along the length direction of the solar cell; and electrode pads. Each busbar electrode is connected to 5 to 10 electrode pads of the electrode pads, the 5 to 10 electrode pads include a first electrode pad and a second electrode pad, an area of the first electrode pad satisfies 0.3 mm² ≤S1≤0.6 mm², and an area of the second electrode pad satisfies 0.8 mm² ≤S2≤1.2 mm².

In some embodiments, the finger electrodes are arranged with different pitches, or the busbar electrodes are arranged with different pitches.

According to yet another aspect, a photovoltaic module is provided. The photovoltaic module includes a plurality of solar cells. The solar cell is the solar cell in the above aspect.

A method for manufacturing a silicon wafer, a solar cell, and a photovoltaic module are provided. With this method, a silicon wafer with chamfers is obtained directly. Moreover, the area of the obtained wafer is greater than the area of the inscribed square of the circumference of the silicon ingot. As a result, the area of the silicon wafer is increased, the utilization rate of the silicon ingot is improved, the performance of the photovoltaic module is improved, and the cost of the photovoltaic module is reduced.

It should be understood that the general description above and the detailed description in the following are merely exemplary and illustrative, and cannot limit the present disclosure.

### BRIEF DESCRIPTION OF DRAWINGS

FIG. 1 is a flowchart of a method for manufacturing a silicon wafer according to the present disclosure;
FIG. 2 is a schematic diagram showing cutting lines in a cross section of a silicon ingot according to the present disclosure;
FIG. 3 is a schematic diagram of a silicon wafer according to the present disclosure;
FIG. 4 is a flowchart of a method of selecting four arc segments on a circumference of the silicon ingot according to chamfering parameters of a solar cell according to the present disclosure;
FIG. 5 is a flowchart of a method of cutting a rectangular body having a rectangular cross-section shape with chamfers along a direction perpendicular to a length direction of the silicon ingot to obtain a rectangular silicon wafer with chamfers according to the present disclosure;
FIG. 6 is a schematic diagram showing cutting lines in a cross section of a silicon ingot according to the present disclosure;
FIG. 7 is a schematic diagram of a solar cell according to an embodiment of the present disclosure;
FIG. 8 is a schematic diagram of a solar cell according to another embodiment of the present disclosure;
FIG. 9 is a schematic diagram of a half-cut solar cell according to the present disclosure;
FIG. 10 is an enlarged view of a region I in FIG. 9;
FIG. 11 is a plan view of a photovoltaic module according to some embodiments of the present disclosure;
FIG. 12 is a plan view of a solar cell according to some embodiments of the present disclosure;
FIG. 13 is a side view of the solar cell according to some embodiments of the present disclosure;
FIG. 14 is a schematic structural diagram of a half-cut solar cell according to some embodiments of the present disclosure;
FIG. 15 is a schematic structural diagram showing a wiring member and solar cells according to some embodiments of the present disclosure;
FIG. 16 is a schematic structural diagram of the photovoltaic module according to an embodiment of the present disclosure;
FIG. 17 is a schematic structural diagram of the photovoltaic module according to another embodiment of the present disclosure; and
FIG. 18 is a schematic structural diagram of the photovoltaic module according to yet another embodiment of the present disclosure.

### Reference signs:

1: silicon ingot;
2: silicon wafer (silicon substrate);
3: cover plate;
4: solar cell;
   41: busbar electrode;
      411: harpoon structure;
         411a: collection portion;
      412: body portion;
   42: finger electrode;
   43: chamfer structure;
   44: electrode pad;
      441: first electrode pad;
      442: second electrode pad;
   45: first surface;
   46: second surface;
5: sealing member;
   51: first sealing member;
   52: second sealing member;
6: half-cut solar cell;
7: wiring member;
8: back plate;
10: solar cell string;
20: encapsulation layer.

The accompanying drawings herein, which are incorporated in and constitute a part of this specification, illustrate embodiments consistent with the present disclosure and, together with the specification, serve to explain principles of the present disclosure.

### DESCRIPTION OF EMBODIMENTS

In order to better understand the technical solutions of the present disclosure, embodiments of the present disclosure will be described in detail below in conjunction with the accompanying drawings.

It should be clear that the described embodiments are only some rather than all of the embodiments of the present disclosure. Based on the embodiments in the present disclosure, all other embodiments obtained by those of ordinary skill in the art without creative efforts fall within the protection scope of the present disclosure.

Terms used in the embodiments of the present disclosure are only for the purpose of describing specific embodiments, and are not intended to limit the present disclosure. Singular forms of "a/an", "the", and "said" used in the embodiments of the present disclosure and the appended claims are intended to include plural forms, unless otherwise clearly specified in the context.

It should be understood that the term "and/or" used herein describes an association relationship between associated objects and represents that three relationships may exist. For example, A and/or B may represent the following three cases: only A exists, both A and B exist, and only B exists. In addition, the character "/" herein generally indicates an "or" relationship between the associated objects.

It is to be noted that orientation terms such as "up", "down", "left", and "right" described in the embodiments of the present disclosure are described from the perspective shown in the accompanying drawings, and should not be construed as limiting the embodiments of the present disclosure. Besides, in this context, it is to be further understood that one element described as being connected "on" or "under" another element not only means that the element may be directly connected "on" or "under" the another element, but also means that the element may be indirectly connected "on" or "under" the another element through an intermediate element.

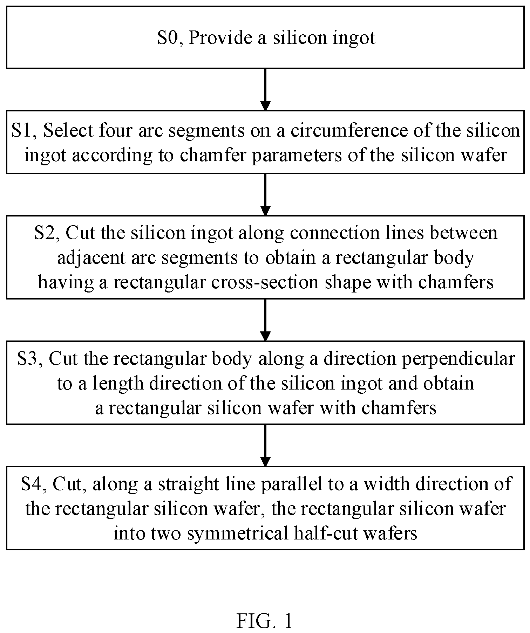

As shown in FIG. 1, FIG. 2, and FIG. 3, embodiments of the present disclosure provide a method for manufacturing a silicon wafer for a photovoltaic module. For example, the method may be used for cutting a cylindrical silicon ingot 1 with a cross-sectional diameter ranging from 252 mm to 277 mm. The method for manufacturing a silicon wafer 2 may include the following steps.

In step S0, a silicon ingot 1 is provided. The silicon ingot 1 may have a circular cross section with a diameter ranging from 252 mm to 277 mm.

In step S1, four arc segments are selected on a circumference of the silicon ingot 1 according to chamfering parameters of the silicon wafer for manufacturing a solar cell 4.

In step S2, the silicon ingot 1 is squared along lines connecting adjacent arc segments to obtain a rectangular body having a rectangular cross-section shape with chamfers. That is, the silicon ingot 1 is cut along lines connecting adjacent chamfered arcs.

In step S3, the rectangular body is cut along a direction perpendicular to a length direction of the silicon ingot 1 to obtain a rectangular silicon wafer with chamfers.

A conventional silicon wafer 2 used as a substrate of the solar cell has a rectangular shape with right angle corners and is prone to stress concentration during use, resulting in breaking of the silicon wafer 2, which affects the quality of the solar cell 4 and the photovoltaic module. Therefore, the silicon wafer 2 in embodiments of the present disclosure is provided with chamfers to reduce a breaking possibility of the silicon wafer 2. The chamfers are arc-shaped. Since a cross section of the silicon ingot 1 is circular, the required arc chamfers can be obtained from a circumference of the cross section of the silicon ingot 1 in the process of cutting the silicon ingot 1 into silicon wafers, so that the silicon wafer 2 with chamfers can be obtained directly, which can reduce a step of chamfering the silicon wafer 2, simplify a manufacturing process of the photovoltaic module, and is more in line with an actual usage requirement. Therefore, four corners of the silicon wafer 2 can be determined by selecting four arc segments on the circumference of the silicon ingot 1, so that a position of the entire silicon wafer 2 can be determined. Next, the silicon ingot 1 is squared. That is, the silicon ingot 1 is cut along the length direction of the silicon ingot 1 to obtain a rectangular body having a rectangular cross-section shape with chamfers. Next, the obtained rectangular body is cut along a direction perpendicular to the length direction of the silicon ingot 1, that is, a radial direction of the silicon ingot 1. In this way, the silicon wafer 2 with chamfers can be obtained. Busbar electrodes and finger electrodes are arranged on the silicon wafer 2, and the solar cell 4 required for the photovoltaic module can be obtained by processing such as soldering. Compared with cutting along an inscribed quadrilateral in the cross section of the silicon ingot 1, an area of the silicon wafer 2 obtained by the method provided in embodiments of the present disclosure is greater than that of the silicon wafer obtained by cutting along an inscribed quadrilateral in the cross section of the silicon ingot. Therefore, a light-receiving area is larger, and utilization of the silicon ingot 1 is higher, which can improve efficiency of the solar cell and the photovoltaic module and reduce costs, and is more in line with an actual usage requirement.

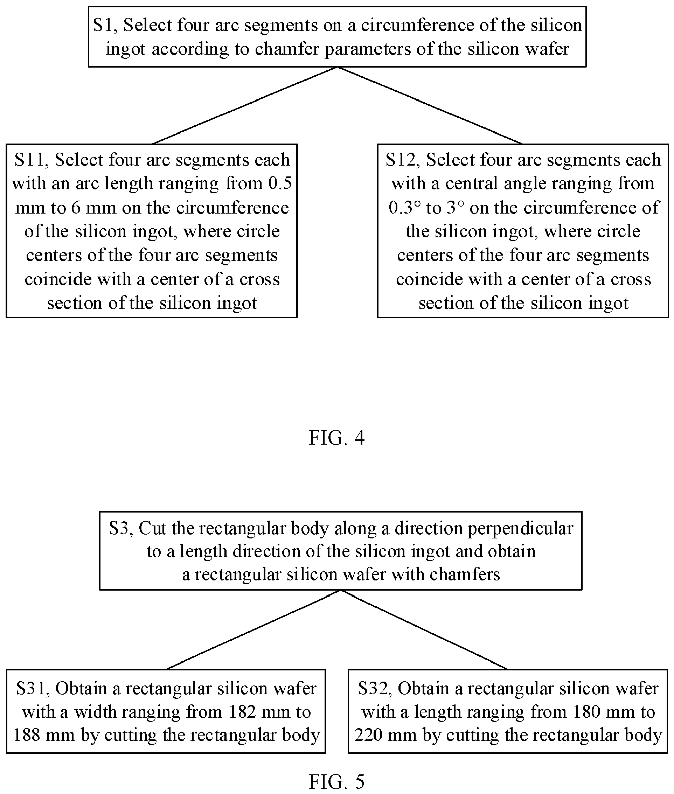

As shown in FIG. 4, in some embodiments, step S1 further includes the following step.

In step S11, four arc segments each having an arc length ranging from 0.5 mm to 6 mm are selected on the circumference of the silicon ingot, and circle centers of the arc segments coincide with a center of the cross section of the silicon ingot.

The rectangular silicon wafer 2 with right angle corners (the silicon wafer 2 without chamfers) has low utilization for the silicon ingot 1, is prone to stress concentration at a right-angle position, and is easily contacted during processing and use, resulting in breaking of the silicon wafer, so that a right-angle part may be broken away from the silicon wafer, which affects an area and quality of the solar cell 4, easily causes failure of the solar cell 4 and the photovoltaic module, and increases the costs.

When the silicon wafer 2 has a larger chamfer, the area of the silicon wafer 2 is reduced more, resulting in a reduction in the area of the silicon wafer 2, thereby affecting efficiency of the solar cell 4 and the photovoltaic module. A smaller chamfer may be obtained by the method provided in the present disclosure, which reduces the breaking possibility of the silicon wafer 2 and further increases the area of the silicon wafer 2, thereby increasing a light-receiving area of the solar cell 4 and being more in line with an actual usage requirement. If the circle centers of the arcs of the chamfers overlap with the center of the cross section of the silicon ingot, the circumference of the silicon ingot 1 after cutting may be directly used as the chamfer of the silicon wafer 2, and no additional processing is required, so as to simplify manufacturing procedures of the solar cell 4 and the photovoltaic module, which is more in line with an actual manufacturing requirement.

As shown in FIG. 4, in some embodiments, step S1 further includes the following step.

In S12, four arc segments each having a central angle ranging from 0.3° to 3° are selected on the circumference of the silicon ingot, and circle centers of the arc segments coincide with a center of the cross section of the silicon ingot.

In this manner, an additional step of processing the silicon wafer 2 to obtain chamfers can be omitted, which is more in line with an actual manufacturing requirement. A smaller arc chamfer can reduce the impact on an actual area of the silicon wafer 2, which increases the area of the silicon wafer 2, thereby improving the efficiency of the solar cell 4 and the photovoltaic module.

Compared with cutting along an inscribed square in the circumference of the silicon ingot 1, the silicon wafer 2 obtained by the method provided in the present disclosure has a larger area, and utilization of the silicon ingot 1 is higher. Therefore, the costs is reduced, and the method is more in line with actual manufacturing and usage requirements.

As shown in FIG. 5, in some embodiments, step S3 includes the following steps.

In step S31, a rectangular silicon wafer with a width ranging from 182 mm to 188 mm is obtained by cutting the rectangular body.

In step S32, a rectangular silicon wafer with a length ranging from 180 mm to 220 mm is obtained by cutting the rectangular body.

Compared with a square silicon wafer 2, the rectangular silicon wafer has a larger area, which increases the light-receiving area of the silicon wafer 2, and has higher utilization for the silicon ingot 1, thereby reducing the costs.

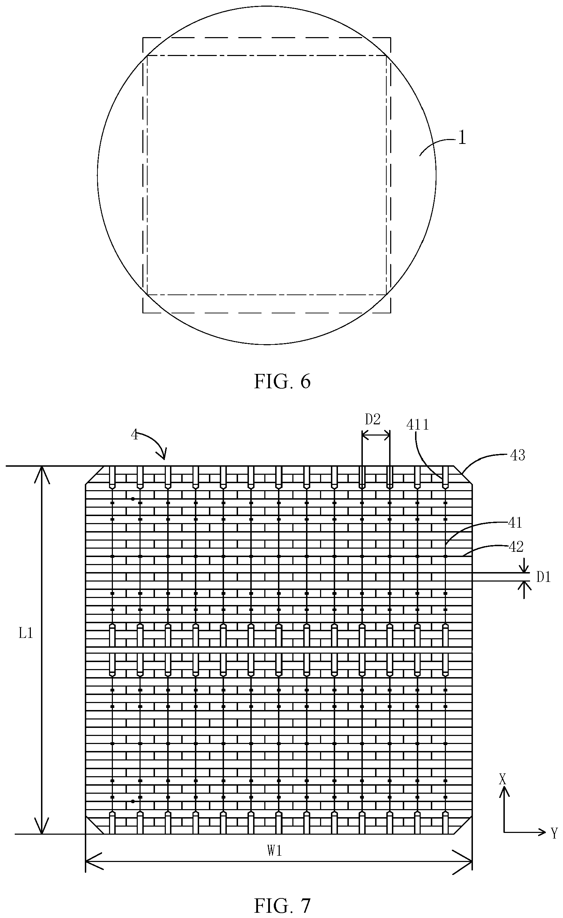

As shown in FIG. 6, the dotted line in the figure is a range of the rectangular silicon wafer obtained by the method provided in the present disclosure, and the dot dash line in the figure is a range of an square silicon wafer obtained by the conventional method. It is well known that the inscribed square of a circle has a largest area among various inscribed quadrilaterals of the circle. As shown in FIG. 7, by use of the method for manufacturing the silicon wafer 2 provided in the present disclosure, the square silicon wafer can completely fall within the range of the silicon wafer 2 obtained by the method provided in the present disclosure. A length and a width of the silicon wafer 2 obtained by the method provided in the present disclosure can be greater than those of the square silicon wafer obtained by conventional methods. Therefore, compared with the related art, with the method for manufacturing the silicon wafer 2 provided in the present disclosure, utilization of the silicon ingot 1 is higher, the area of the solar cell 4 is increased, the efficiency of the solar cell 4 and the photovoltaic module is improved, the cost is reduced, and the method is more in line with an actual usage requirement.

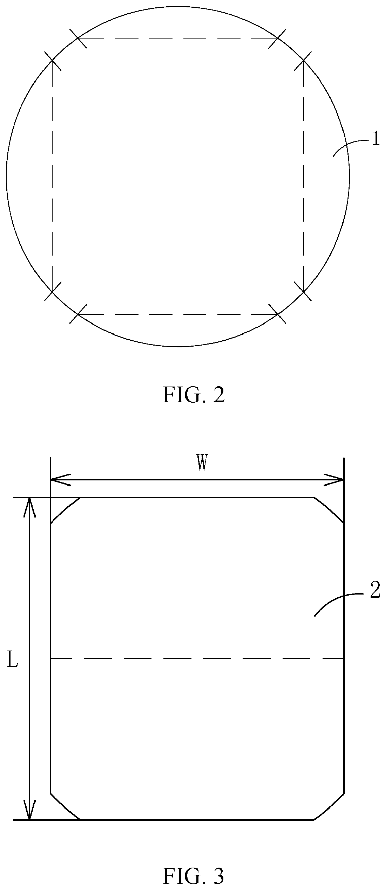

As shown in FIG. 3, a width W of the silicon wafer 2 may be 182 mm, 183 mm, 184 mm, 185 mm, 186 mm, 187 mm, 188 mm, or the like. A length L of the silicon wafer 2 may be 180 mm, 184 mm, 188 mm, 192 mm, 196 mm, 200 mm, 204 mm, 208 mm, 212 mm, 216 mm, 220 mm, or the like.

The silicon wafer 2 may be rectangular. Such a design is conducive to transportation after layout and improves space utilization. Moreover, compared with the square silicon wafer 2, the rectangular silicon wafer 2 has a larger area, which improves the efficiency of the silicon wafer 2 and the photovoltaic module, improves utilization of the silicon ingot 1 and reduces the costs, and is more in line with an actual usage requirement. A size of the solar cell 4 may be the same as that of the silicon wafer 2.

Taking the cutting of the silicon ingot 1 with a diameter of 252 mm as an example, the square silicon wafer obtained by conventional methods is generally 182 mm, and the size of the rectangular silicon wafer obtained by the method of the present disclosure may be 182 mm in width and 190 mm in length. A cross-sectional area of the silicon ingot 1 is approximately 49875.925 mm². The silicon ingot 1 is cut using the conventional methods and the method of the present disclosure to obtain a square silicon wafer and a rectangular silicon wafer. An area of the square silicon wafer is approximately 33094.7715 mm², and an area of the rectangular silicon wafer is approximately 34454.6839 mm². For the square silicon wafer, the utilization of the silicon ingot 1 is 33094.7715/49875.925, which is approximately equal to 66.3%. For the rectangular silicon wafer, the utilization of the silicon ingot 1 is 34454.6839/49875.925, which is approximately equal to 69.1%. Through actual calculation, it may be concluded that the silicon wafer 2 obtained by the method provided in the present disclosure can significantly improve the utilization of the silicon ingot 1, thereby reducing the costs and being more in line with an actual manufacturing requirement.

Moreover, the photovoltaic module including the silicon wafer 2 obtained using the method provided in the present disclosure better matches a size of a container, thereby improving efficiency of the photovoltaic module and also improving transportation efficiency.

As shown in FIG. 1, in some embodiments, the method for manufacturing a silicon wafer 2 may include the following step.

In S4, the rectangular silicon wafer is divided into two symmetrical half-cut solar cells along a straight line parallel to a width direction of the rectangular silicon wafer.

Generally, the solar cell 4 used in the photovoltaic module has a half-cut solar cell structure. Compared with the whole-piece structure, the photovoltaic module using the half-cut solar cell structure is more efficient. Therefore, the silicon wafer 2 can be cut during the processing to obtain the half-cut solar cells. The step of cutting to obtain half-cut solar cells may be performed after the silicon wafer 2 is processed into the solar cell 4.

In some embodiments, the step of cutting to obtain half-cut solar cells may be performed during the manufacturing of the silicon wafer 2 or performed during the manufacturing of the solar cell 4 or performed during the manufacturing of the photovoltaic module.

In some embodiments, during the manufacturing of the silicon wafer 2, the silicon ingot 1 may be directly squared/cut, the silicon ingot 1 is cut into a rectangular body having a rectangular cross-section shape or a rectangular body having a rectangular cross-section shape with chamfers, and a cross-sectional area of the rectangular body obtained by cutting the silicon ingot 1 is larger than the area of the required silicon wafer 2. The rectangular body is cut into silicon wafers, and then, the silicon wafer 2 is processed according to chamfering parameters of the required solar cell 4 to obtain the silicon wafer 2 with chamfers. The silicon wafer 2 with right angle corners is prone to breaking and cracks during use, which affects the quality of the solar cell 4 and the photovoltaic module. Therefore, the silicon wafer 2 with chamfers is generally used to manufacture the solar cell 4 and the photovoltaic module.

In some embodiments, the diameter of the silicon ingot 1 may be increased, and a rectangular silicon wafer with right angle corners (without a chamfer structure) is directly obtained by cutting the silicon ingot. The rectangle may be an inscribed quadrilateral of the circular cross section of the silicon ingot 1, or a rectangle with an area smaller than that of the inscribed quadrilateral of the circular cross section of the silicon ingot 1. After cutting, the rectangular silicon wafer with right angle corners may be used directly as required or be further processed to make the rectangular silicon wafer have chamfers.

Some embodiments of the present disclosure further provide a solar cell. The solar cell includes a silicon substrate. The silicon wafer obtained by the method as referred to in any one of the above embodiments is used as the silicon substrate. Since the silicon wafer has the above technical effects, the solar cell including the silicon wafer also has the corresponding technical effects. Details are not described herein again.

As shown in FIG. 7, some embodiments of the present disclosure provide a solar cell 4. The solar cell 4 has a length dimension L1 ranging from 190 mm to 220 mm and a width dimension W1 ranging from 177 mm to 187 mm. The solar cell 4 includes N finger electrodes 42. The N finger electrodes 42 are arranged along a length direction X of the solar cell 4. The quantity N of the finger electrodes 42 satisfies 130≤N≤190, and a central angle α corresponding to an arc length of the chamfer structure 43 satisfies 0.3°≤α≤3°.

The solar cell 4 is a rectangular solar cell 4. The length L1 of the solar cell 4 may be 190 mm, 195 mm, 200 mm, 205 mm, 210 mm, 215 mm, or 220 mm, or may be other values in the above range. The width W1 of the solar cell 4 may be 177 mm, 178 mm, 179 mm, 180 mm, 181 mm, 182 mm, 183 mm, 184 mm, 185 mm, 186 mm, or 187 mm, or may be other values in the above range. The quantity of the finger electrodes 42 may be determined by a specific dimension of the solar cell 4. For example, the quantity N of the finger electrodes 42 may be 130, 135, 140, 145, 150, 155, 160, 165, 170, 175, 180, 185, or 190, or may be other values in the above range. The solar cell 4 is made with the silicon wafer 2 as the substrate and is manufactured through a series of processes such as texturing, diffusion, and etching. A size of the silicon wafer 2 may be regarded as a size of the solar cell 4, and a shape of the silicon wafer 2 may be regarded as a shape of the solar cell 4. The silicon wafer 2 is processed by cutting the silicon ingot 1, and the cross-section of the silicon ingot 1 is circular. After the silicon wafer 2 is obtained by cutting the silicon ingot 1, the silicon wafer 2 may have chamfer structures 43. The silicon wafer 2 may have four chamfer structures 43 located at four corners of the rectangular silicon wafer. A central angle α corresponding to an arc length of the chamfer structure 43 may be 0.3°, 0.5°, 0.7°, 0.9°, 1°, 1.2°, 1.5°, 1.7°, 2°, 2.2°, 2.5°, 2.8°, or 3°, or may be other values in the above range.

The photovoltaic module may convert solar energy into electrical energy. The photovoltaic modules are transported containers after leaving factory. Due to the limitation of the size of the solar cell 4, the overall size of the conventional photovoltaic module does not match a size of the container. As a result, there is still remaining space inside the container, leading to a waste of space of the container and an increase in logistics costs. However, in some embodiments of the present disclosure, the size of the solar cell 4 is reasonably designed, so that the size of the photovoltaic module can match the size of the container, and the photovoltaic module can make full use of the space inside the container, thereby improving utilization of the space of the container and helping to reduce costs of logistics and transportation of the photovoltaic module. In addition, the quantity of the finger electrodes on the conventional solar cell is unreasonably designed, which affects current transmission efficiency of the finger electrodes and blocks sunlight, resulting in a reduction in the light-receiving area of the solar cell and a reduction in efficiency of the solar cell. However, in some embodiments of the present disclosure, the quantity of the finger electrodes 42 is limited, which ensures the current transmission efficiency of the finger electrodes 42, reduces a light-shielding area caused by the finger electrodes 42, and further improves the efficiency of the solar cell 4, thereby improving the efficiency of the photovoltaic module. In addition, the central angle of the arc length of the chamfer structure 43 on the solar cell 4 is controlled, which improving utilization of the silicon ingot 1 during the process of cutting the silicon ingot 1 to obtain the silicon wafer 2, reduces a possibility of stress concentration on an edge of the solar cell 4, and prolongs the service life of the solar cell 4.

In some embodiments, the length L1 of the solar cell 4 satisfies 190 mm≤L1<200 mm, and the quantity N of the finger electrodes 42 satisfies 145≤N≤165.

For example, the length L1 of the solar cell 4 may be 190 mm, 191 mm, 192 mm, 193 mm, 194 mm, 195 mm, 196 mm, 197 mm, 198 mm, 199 mm, or 200 mm, or may be other values in the above range. When L1 is within the above range, the quantity N of the finger electrodes 42 may be 145, 148, 151, 154, 157, 160, 163, or 165, or may be other values in the above range. The size of the solar cell 4 and the quantity of the finger electrodes 42 are further designed, so that the quantity of the finger electrodes 42 can match the length of the solar cell 4, which further improves the efficiency of the solar cell 4.

In some embodiments, the length L1 of the solar cell 4 satisfies 200 mm≤L1≤220 mm, and the quantity N of the finger electrodes 42 satisfies 160≤N≤180.

For example, the length L1 of the solar cell 4 may be 200 mm, 201 mm, 202 mm, 203 mm, 204 mm, 205 mm, 206 mm, 207 mm, 208 mm, 209 mm, 210 mm, 211 mm, 212 mm, 213 mm, 214 mm, 215 mm, 216 mm, 217 mm, 218 mm, 219 mm, or 220 mm, or may be other values in the above range. When L1 is within the above range, the quantity N of the finger electrodes 42 may be 160, 162, 164, 166, 168, 170, 172, 174, 176, 178, or 180, or may be other values in the above range. The size of the solar cell 4 and the quantity of the finger electrodes 42 are further designed, so that the quantity of the finger electrodes 42 can match the length of the solar cell 4, which further improves the efficiency of the solar cell 4.

As shown in FIG. 7, in some embodiments, along the length direction X of the solar cell 4, a distance D1 between adjacent finger electrodes 42 satisfies 1 mm≤D1≤3 mm.

D1 may be 1 mm, 1.2 mm, 1.5 mm, 1.7 mm, 1.9 mm, 2 mm, 2.3 mm, 2.5 mm, 2.8 mm, or 3 mm. The configuration of the distance D1 between adjacent finger electrodes 42 facilitates the finger electrodes 42 to collect and conduct a current generated by the solar cell 4, thereby improving the efficiency of the solar cell 4.

In some embodiments, the N finger electrodes 42 are evenly arranged along the length direction X of the solar cell 4.

Along the length direction X of the solar cell 4, distances between adjacent finger electrodes 42 are equal, which further improves the efficiency of the solar cell 4.

As shown in FIG. 7, in some embodiments, the solar cell 4 further includes M busbar electrodes 41, the M busbar electrodes 41 are arranged along a width direction Y of the solar cell 4, the busbar electrodes 41 intersect with the finger electrodes 42 and are electrically connected to the finger electrodes 42, and the quantity M of the busbar electrodes 41 satisfies 16≤M≤20.

The quantity M of the busbar electrodes 41 may be 16, 17, 18, 19, or 20. For example, each of the busbar electrodes 41 may include a harpoon structure 411. The busbar electrode 4 may include two harpoon structures 411 at two ends of the busbar electrode 4. The harpoon structure 411 may be referred to as an extension portion or an edge portion. The harpoon structure 411 can collect the current at the edge of the solar cell 4, thereby improving the efficiency of the solar cell 4. Through the configuration of the quantity of the busbar electrodes 41, a light-shielding area of the busbar electrodes 41 is reduced, and the current transmission efficiency of the busbar electrodes 41 is ensured, thereby further improving the efficiency of the solar cell 4.

As shown in FIG. 7, in some embodiments, along the width direction Y of the solar cell 4, a distance D2 between adjacent busbar electrodes 41 satisfies 9 mm≤D2≤12 mm.

D2 may be 9 mm, 9.5 mm, 10 mm, 10.5 mm, 11 mm, 11.5 mm, or 12 mm. The limitation on the distance between the adjacent busbar electrodes 41 facilitates the busbar electrodes 41 to collect and conduct the current generated by the solar cell 4, thereby improving the efficiency of the solar cell 4.

In some embodiments, the M busbar electrodes 41 are evenly arranged along the width direction Y of the solar cell 4.

Along the width direction Y of the solar cell 4, distances between adjacent busbar electrodes 41 are equal, which further improving the efficiency of the solar cell 4.

In some embodiments, the solar cell 4 has four chamfer structures 43, and central angles corresponding to arc lengths of the four chamfer structures 43 are equal.

Four corners of the solar cell 4 have identical chamfer structures 43. This design facilitates the cutting and manufacturing of the silicon wafer 2 and reduces the cutting difficulty of the silicon wafer 2. In addition, the solar cell 4 using this design facilitates obtaining two half solar cells of a same size and area by cutting, thereby facilitating the formation of the photovoltaic module.

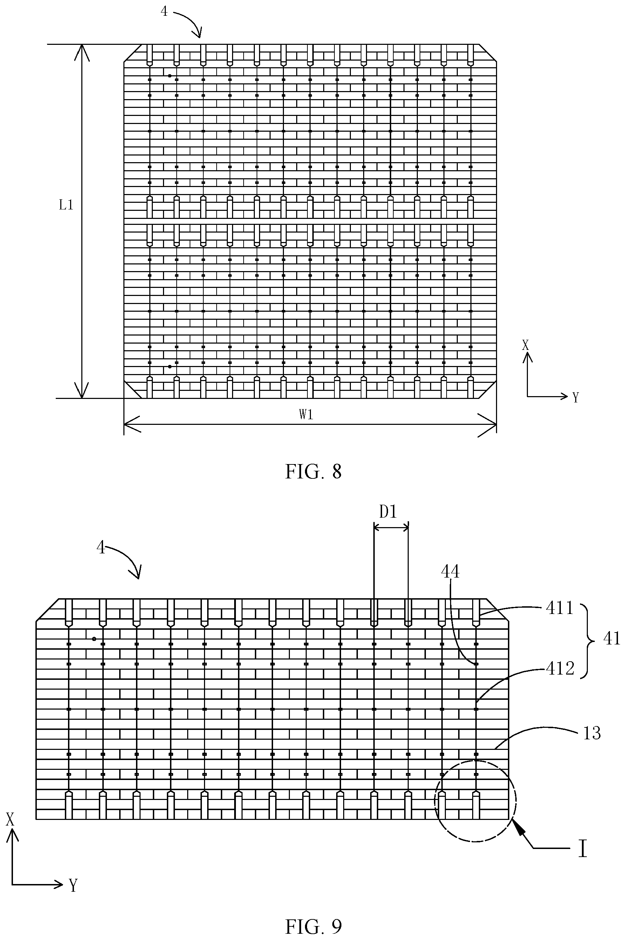

As shown in FIG. 8 to FIG. 10, some embodiments of the present disclosure provide a solar cell 4. The solar cell 4 has a length L1 ranging from 190 mm to 220 mm and a width W1 ranging from 177 mm to 187 mm. The solar cell 4 is cut into at least two fragments. For example, the solar cell 4 is cut into two half-cut solar cells 6. Each of the half-cut solar cell 6 includes: a substrate, busbar electrodes 41, and electrode pads 44. The silicon wafer 2 may be used as the substrate. The busbar electrodes 41 are arranged on the substrate, and are connected to the substrate through the electrode pads 44. Each of the busbar electrodes 41 is connected to 5 to 10 electrode pads 44, and the electrode pads 44 are arranged at intervals along the busbar electrode 41. The busbar electrode 41 includes a body portion 412 and a harpoon structure 411. For example, the busbar electrode 41 includes two harpoon structures 411 located at two ends of the body portion 412. The harpoon structure 411 includes at least one collection portion 411a. The collection portion 411a extends towards an edge of the half-cut solar cell 6. Along a length direction X of the solar cell 4, a length L2 of the collection portion 411a satisfies 5 mm≤L2≤8 mm.

The solar cell 4 is a rectangular solar cell 4. The length L1 of the solar cell 4 may be 190 mm, 192 mm, 194 mm, 196 mm, 198 mm, 200 mm, 202 mm, 204 mm, 206 mm, 208 mm, 210 mm, 212 mm, 214 mm, 216 mm, 218 mm, or 220 mm, or may be other values in the above range. The width W1 of the solar cell 4 may be 177 mm, 178 mm, 179 mm, 180 mm, 181 mm, 182 mm, 183 mm, 184 mm, 185 mm, 186 mm, or 187 mm, or may be other values in the above range. The half-cut solar cell 6 may be formed by cutting the solar cell 4. For example, the half-cut solar cell 6 may be half of, one-third of, or a quarter of the solar cell 4. The substrate of the half-cut solar cell 6 may be a silicon substrate. Busbar electrodes 41 are arranged on the substrate. The busbar electrodes 41 can collect and conduct currents. The busbar electrodes 41 are connected to the substrate through electrode pads 44. The solar cell 6 includes a plurality of busbar electrodes 41, and the plurality of busbar electrodes 41 are arranged along the width direction Y of the solar cell 4. For each busbar electrode 41, a quantity of the electrode pads 44 may be 5, 6, 7, 8, 9, or 10. The busbar electrode 41 has a body portion 412 and a harpoon structure 411. For example, each busbar 41 may have two harpoon structures 411, and the two harpoon structures 411 are respectively located on two ends of the body portion 412. The harpoon structure 411 may include two collection portions 411a, and the two collection portions 411a are arranged along the width direction Y of the solar cell 4. There is a certain distance between the two collection portions 411a. The two collection portions 411a may be parallel to each other, or the two collection portions 411a may be inclined to each other. A length L2 of the collection portion 411a may be 5 mm, 6 mm, 7 mm, or 8 mm, or may be other values in the above range. The collection portion 411a can collect a current at an edge of the half-cut solar cell 6, thereby improving efficiency of the half-cut solar cell 6. The substrate may be further provided with a plurality of finger electrodes 42 intersecting with the busbar electrodes 41. The plurality of finger electrodes 42 are arranged along the length direction X of the solar cell 4, and the harpoon structure 411 may be electrically connected to multiple of the finger electrodes 42.

The photovoltaic module may convert solar energy into electrical energy, and may be transported through a container. Due to the limitation of the size of the solar cell 4, it is difficult to match an overall size of the conventional photovoltaic module with a size of the container. As a result, there is still remaining space inside the container, leading to a waste of space of the container and an increase in logistics costs. However, in some embodiments of the present disclosure, the size of the solar cell 4 is reasonably designed, so that the size of the photovoltaic module can match the size of the container, and the photovoltaic module can make full use of the space inside the container, thereby improving utilization of the space of the container and reducing costs of logistics and transportation of the photovoltaic module. On the other hand, the conventional half-cut solar cell 6 is less efficient. However, in some embodiments of the present disclosure, the busbar electrode 41 is provided with the harpoon structure 411, and the length of the collection portion 411a of the harpoon structure 411 is reasonably designed to facilitate the collection of the current at the edge of the half-cut solar cell 6, thereby improving the efficiency of the half-cut solar cell 6. In addition, through the control over the quantity of the electrode pads 44 on each busbar electrode 41, an overall area of the electrode pads 44 can be reduced while a stable connection between the busbar electrode 41 and the substrate is ensured, that is, a light-shielding area of the electrode pads 44 is reduced, which improves the efficiency of the half-cut solar cell 6 and reduces consumption of metal paste required for the electrode pads 44, thereby reducing manufacturing costs of the half-cut solar cell 6.

In some embodiments, the electrode pads 44 on each busbar electrode 41 are evenly arranged.

On each busbar electrode 41, the plurality of electrode pads 44 are arranged at intervals along the length direction X of the solar cell 4, and distances between adjacent electrode pads 44 are equal. This design improves stability of the connection between the busbar electrode 41 and the substrate. Moreover, the current generated by the half-cut solar cell 6 is better collected at the electrode pad 44 and then is outputted to the outside, thereby improving the efficiency of the half-cut solar cell 6.

The finger electrodes are arranged with different pitches, and/or the busbar electrodes are arranged with different pitches.

In some embodiments, from a center of the half-cut solar cell 6 to the edge of the half-cut solar cell 6, distances between adjacent electrode pads 44 on each of the busbar electrodes 41 gradually increase.

On each busbar electrode 41, a distance between the electrode pads 44 located in a center region of the half-cut solar cell 6 may be smaller, a distance between the electrode pads 44 located at the edge of the half-cut solar cell 6 may be larger, and the electrode pads 44 on two ends of the busbar electrode 41 may be arranged symmetrically. This design improves stability of the connection between the busbar electrode 41 and the substrate, reduces a possibility of cracks of the half-cut solar cell 6, and also improves the efficiency of the half-cut solar cell 6.

In some embodiments, from the center of the half-cut solar cell 6 to the edge of the half-cut solar cell 6, distances between adjacent electrode pads 44 on each of the busbar electrodes 41 gradually decrease.

On each busbar electrode 41, the distance between the electrode pads 44 located in the center region of the half-cut solar cell 6 may be larger, the distance g between the electrode pads 44 located at the edge of the half-cut solar cell 6 may be smaller, and the electrode pads 44 on two ends of the busbar electrode 41 may be arranged symmetrically. In the half-cut solar cell 6 in some embodiments of the present disclosure, the distance between the electrode pads 44 on the busbar electrode 41 may be adjusted according to an actual use condition, which improves the stability of the connection between the busbar electrode 41 and the substrate and also improves the efficiency of the half-cut solar cell 6.

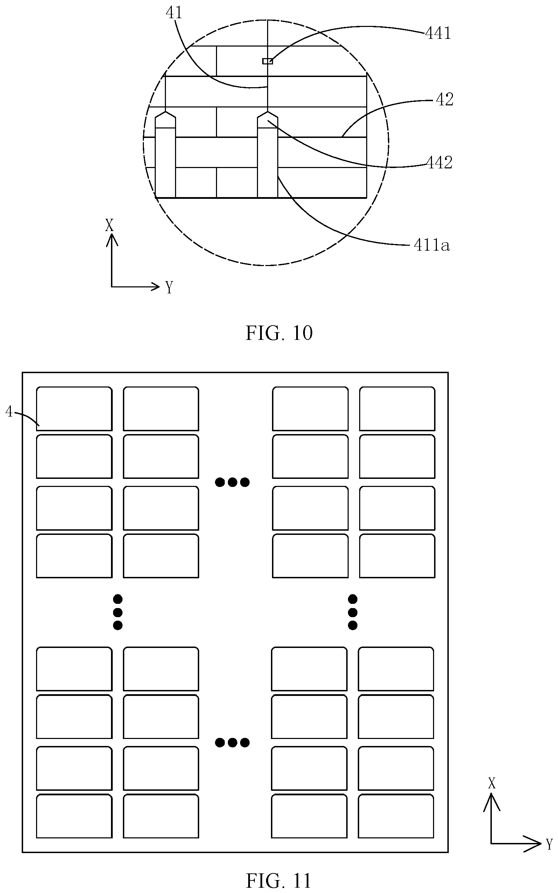

As shown in FIG. 10, in some embodiments, the electrode pads 44 include a first electrode pad 441 and a second electrode pad 442, the body portion 412 is connected to the substrate through the first electrode pad 441, the harpoon structure 411 is connected to the substrate through the second electrode pad 442, and an area of the second electrode pad 442 is greater than that of the first electrode pad 441.

The first electrode pad 441 and the second electrode pad 442 may be in a shape of a rectangle, a circle, a triangle, a polygon, or in other shapes. Since the soldering difficulty of the harpoon structure 411 is large, weak or pseudo soldering may occur, and the second electrode 442 requires a larger area. This design improves stability of the connection between the harpoon structure 411 and the substrate, thereby improving stability of operation of the half-cut solar cell 6. Moreover, through the adjustment of the areas of the first electrode pad 441 and the second electrode pad 442, weak or pseudo soldering of the harpoon structure 411 is reduced, and the light-shielding area of the electrode pads 44 is reduced, thereby improving the efficiency of the half-cut solar cell 6.

In some embodiments, the area S1 of the first electrode pad 441 satisfies 0.3 mm²≤S1≤0.6 mm².

S1 is an area of a projection of the first electrode pad 441 on the substrate along a thickness direction Z of the solar cell 4. S1 may be 0.3 mm², 0.34 mm², 0.38 mm², 0.4 mm², 0.44 mm², 0.48 mm², 0.5 mm², 0.54 mm², 0.58 mm², or 0.6 mm², or may be other values in the above range. For example, the first electrode pad 441 may be 0.8 mm×0.6 mm, 0.7 mm×0.7 mm, or 0.7 mm×0.8 mm, or other lengths and widths satisfying the above range of S1.

The area of the first electrode pad 441 is arranged within a reasonable range, which reduces a light-shielding area of the first electrode pad 441, thereby improving operational efficiency of the half-cut solar cell 6, reducing consumption of metal paste required for forming the electrode pads 44, and reducing manufacturing costs of the half-cut solar cell 6.

In some embodiments, the area S2 of the second electrode pad 442 satisfies 0.8 mm²≤S2≤1.2 mm².

S2 is an area of a projection of the second electrode pad 442 on the substrate along the thickness direction Z of the solar cell 4. S2 may be 0.8 mm², 0.83 mm², 0.86 mm², 0.9 mm², 0.93 mm², 0.96 mm², 1 mm², 1.1 mm², or 1.2mm², or may be other values in the above range. For example, the second electrode pad 442 may be 1.2 mm×0.8 mm, 1.2 mm×0.9 mm, or 1.1 mm×0.9 mm, or may be other lengths and widths satisfying the above range of S2.

The area of the second electrode pad 442 is arranged within a reasonable range, which improves stability of soldering between the harpoon structure 411 and the substrate, reduces a possibility of weak or pseudo soldering, and also reduces a light-shielding area of the second electrode pad 442 and consumption of metal paste required for forming the electrode pads 44, thereby improving operational efficiency of the half-cut solar cell 6 and reducing manufacturing costs of the half-cut solar cell 6.

As shown in FIG. 9, in some embodiments, the half-cut solar cell 6 includes a plurality of busbar electrodes 41, and along the width direction Y of the solar cell 4, the distance D1 between adjacent busbar electrodes 41 satisfies 8 mm≤D1≤12 mm.

The plurality of busbar electrodes 41 may be evenly arranged along the width direction Y of the solar cell 4. D1 may be 8 mm, 9 mm, 10 mm, 11 mm, or 12 mm, or may be other values in the above range. This design facilitates the busbar electrodes 41 to collect and conduct the current generated by the half-cut solar cell 6, thereby improving the efficiency of the half-cut solar cell 6.

In some embodiments, a quantity of the busbar electrodes 41 is 16 to 20.

The quantity of the busbar electrodes 41 may be 16, 17, 18, 19, or 20. Through limiting the quantity of the busbar electrodes 41, a light-shielding area of the busbar electrodess 41 is reduced while current transmission efficiency is ensured, thereby further improving the efficiency of the half-cut solar cell 6.

As shown in FIG. 11 to FIG. 13, some embodiments of the present disclosure provide a solar cell 4, including half-cut solar cells 6. The half-cut solar cell 6 is half of the solar cell 4 and is formed by cutting the rectangular solar cell 4. A ratio of the length to the width of the solar cell 4 is greater than 1 or less than or equal to 1.2. A thickness of the half-cut solar cell 6 is 85 µm to 125 µm.

The half-cut solar cell 6 is formed by cutting the solar cell 4. The photovoltaic module includes a plurality of half-cut solar cells 6 connected to each other. A size of the solar cell 4 may affect a size of the photovoltaic module. The ratio of the length to the width of the solar cell 4 may be 1.05, 1.1, 1.15, 1.2, or the like. A width of the solar cell 4 ranges from 175 mm to 187 mm, which may be, for example, 175 mm, 176 mm, 177 mm, 178 mm, 179 mm, 180 mm, 181 mm, 182 mm, 183 mm, 184 mm, 185 mm, 186 mm, 187 mm, or the like, and a length of the solar cell 4 ranges from 186 mm to 220 mm, which may be, for example, 186 mm, 191 mm, 196 mm, 201 mm, 206 mm, 211 mm, 216 mm, 220 mm, or the like, thereby improving the matching between the photovoltaic module and the container, improving space utilization in the container during transportation of the photovoltaic module, and facilitating the transportation of the photovoltaic module. The thickness of the half-cut solar cell 6 may be 85 µm, 90 µm, 95 µm, 100 µm, 105 µm, 110 µm, 115 µm, 120 µm, 125 µm, or the like. Compared with the conventional photovoltaic module, the thickness of the half-cut solar cell 6 in the present disclosure is smaller, which reducing manufacturing costs of the half-cut solar cell 6.

As shown in FIG. 11, in some embodiments, the photovoltaic module has a length ranging from 2380 mm to 2384 mm and a width ranging from 1130 mm to 1138 mm.

The length of the photovoltaic module may be 2380 mm, 2381 mm, 2382 mm, 2383 mm, 2384 mm, or the like, and the width of the photovoltaic module may be 1130 mm, 1131 mm, 1132 mm, 1133 mm, 1134 mm, 1135 mm, 1136 mm, 1137 mm, 1138 mm, or the like. By configuring the size of the photovoltaic module, the photovoltaic module better matches the container in size, which improves space utilization in the container, facilitates transportation of the photovoltaic module, and reduces transportation costs of the photovoltaic module.

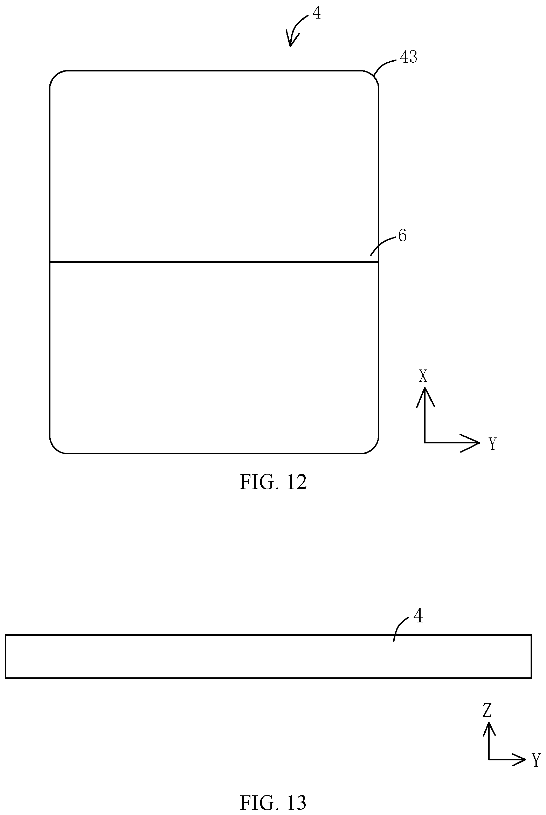

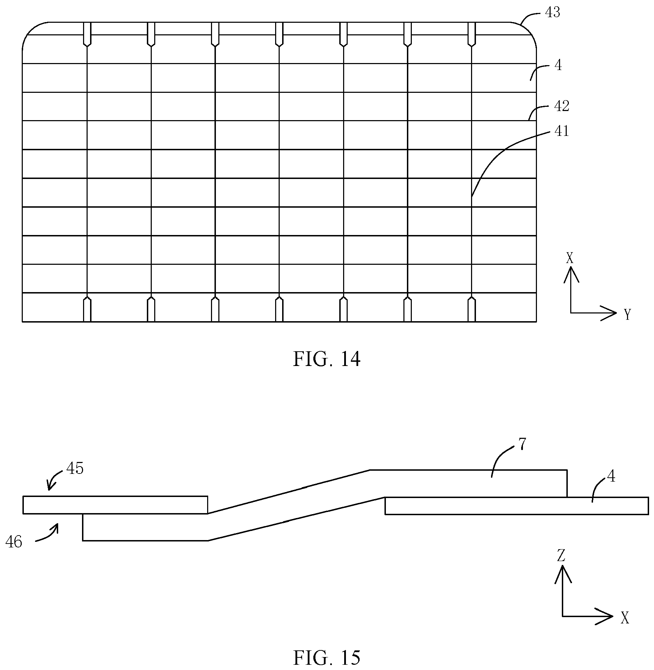

As shown in FIG. 12 and FIG. 14, in some embodiments, the half-cut solar cell 6 has a width of 175 mm to 187 mm and a length of 93 mm to 98 mm.

The solar cell 4 is cut into half-cut solar cells 6 along the width direction Y of the solar cell 4. Therefore, the width of the half-cut solar cell 6 is same as the width of the solar cell 4, and the length of the half-cut solar cell 6 is less than the length of the solar cell 4. The width of the half-cut solar cell 6 may be 175 mm, 176 mm, 177 mm, 178 mm, or the like. Since the width of the photovoltaic module is 1130 mm to 1138 mm, along the width direction Y of the photovoltaic module, the photovoltaic module may include 6 half-cut solar cells 6. The length of the half-cut solar cell 6 may be 93 mm, 94 mm, 95 mm, 96 mm, 97 mm, 98 mm, or the like. Since the length of the photovoltaic module is 2380 mm to 2384 mm, along the length direction X of the photovoltaic module, the photovoltaic module may include 24 half-cut solar cells 6. An effective area of the half-cut solar cells 6 in the photovoltaic module is increased, which improves power conversion efficiency of the photovoltaic module.

As shown in FIG. 12 and FIG. 14, in some embodiments, the half-cut solar cell 6 has a width of 175 mm to 178 mm, and a length of 103 mm to 110 mm.

The solar cell 4 is cut into half-cut solar cells 6 along the width direction Y of the photovoltaic module. Therefore, the width of the half-cut solar cell 6 is same as the width of the solar cell 4, and the length of the half-cut solar cell 6 is less than the length of the solar cell 4. The width of the half-cut solar cell 6 may be 175 mm, 176 mm, 177 mm, 178 mm, or the like. Since the width of the photovoltaic module is 1130 mm to 1138 mm, along the width direction Y of the photovoltaic module, the photovoltaic module may include 6 half-cut solar cells 6. The length of the half-cut solar cell 6 may be 103 mm, 104 mm, 105 mm, 106 mm, 107 mm, 108 mm, 109 mm, 110 mm, or the like. Since the length of the photovoltaic module is 2380 mm to 2384 mm, along the length direction X of the photovoltaic module, the photovoltaic module may include 22 half-cut solar cell 6. An overall area of the half-cut solar cells 6 in the photovoltaic module is increased, which improves power conversion efficiency of the photovoltaic module.

As shown in FIG. 14, in some embodiments, the half-cut solar cell 6 includes busbar electrodes 41 and finger electrodes 42. The busbar electrodes 41 are arranged along the length direction X of the photovoltaic module, and the finger electrodes 42 are arranged along the width direction Y of the photovoltaic module. A quantity of the finger electrodes 42 in the half-cut solar cell 6 is 65 to 95.

The half-cut solar cell 6 is configured to convert solar energy into electrical energy, and a potential difference is generated by a photovoltaic effect of a crystalline silicon solar cell. The finger electrodes 42 in the half-cut solar cell 6 are configured to collect the electrical energy generated in the half-cut solar cell 6. The busbar electrodes 41 are configured to collect electrical energy in the finger electrodes 42 and then transport the electrical energy out of the half-cut solar cell 6. The quantity of the finger electrodes 42 in the half-cut solar cell 6 may be 65, 68, 71, 74, 77, 80, 83, 89, 92, 95, or the like. By increasing the quantity of the finger electrodes 42 in the half-cut solar cell 6, power conversion efficiency of the half-cut solar cell 6 is increased.

As shown in FIG. 14, in some embodiments, the half-cut solar cell 6 is rectangular. In two opposite edges of the half-cut solar cell 6 opposite along the length direction X of the solar cell 4, one is provided with chamfer structures 43 at two ends, and the other may have right angles at two ends.

The solar cell 4 is formed by cutting a silicon ingot. A cross section of the silicon ingot is circular. The chamfer structures 43 provided at the four corners of the rectangular solar cell 4 are edges of the silicon ingot, which improves utilization of the silicon ingot and reducing manufacturing costs of the half-cut solar cells 6. The half-cut solar cells 6 are formed by cutting the solar cell 4, so there are two chamfered structures 43 and two right angles at the four corners of the half-cut solar cell 6. When the half-cut solar cell 6 is subjected to an external force, the chamfer structure 43 provided on the corner of the half-cut solar cell 6 can reduce stress on the edge of the half-cut solar cell 6 6, which reduces a possibility of cracks in the half-cut solar cell 6 6 and improves reliability of the half-cut solar cell 6 6.

As shown in FIG. 14, in some embodiments, the edge of the chamfer structure 43 is arc-shaped, and an arc length of the arc-shaped chamfer structure 43 is 1 mm to 10 mm.

The arc length of the chamfer structure 43 may be 1 mm, 2 mm, 3 mm, 4 mm, 5 mm, 6 mm, 7 mm, 8 mm, 9 mm, 10 mm, or the like. The arc-shaped chamfer structure 43 is the edge of the ingot. The longer the arc length, the more fully the ingot is utilized. If the arc length of the arc-shaped chamfer structure 43 is greater than 10 mm, the half-cut solar cell 6 6 may have a smaller effective area, which reduces power conversion efficiency of the half-cut solar cell 6.

Based on the solar cell 4 provided in the above embodiments, some embodiments of the present disclosure further provide a photovoltaic module. The photovoltaic module includes a solar cell 4. The solar cell 4 may be the solar cell 4 as referred to in any one of the above. Since the solar cell 4 has the above technical effects, the photovoltaic module including the solar cell 4 also has the corresponding technical effects. Details are not described herein again.

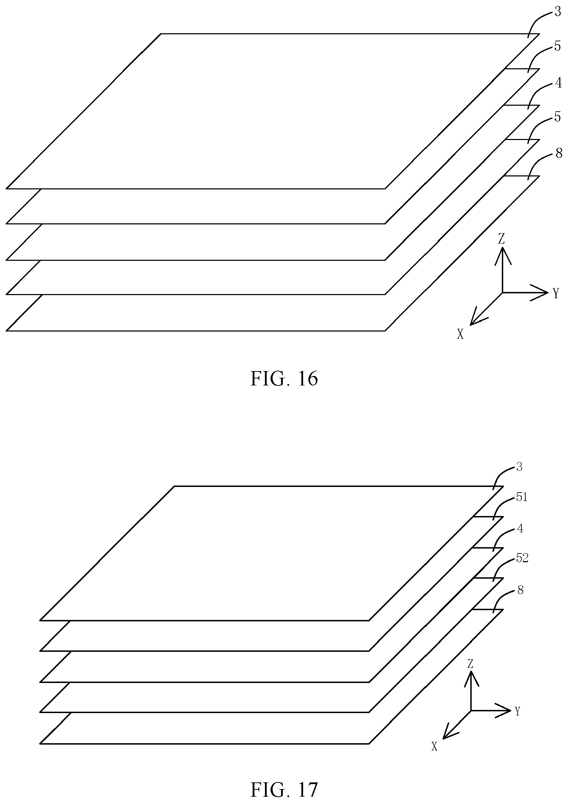

As shown in FIG. 16, the photovoltaic module further includes a sealing member 5, photovoltaic glass, and a back plate 8. The sealing member 5 is configured to connect a cover plate 3, the half-cut solar cells 6, and the back plate 8. The sealing member 5 includes a first sealing member 51 and a second sealing member 52. Along the thickness direction Z of the photovoltaic module, the cover plate 3, the first sealing member 51, the half-cut solar cells 6, the second sealing member 52, and the back plate 8 are arranged sequentially. The sealing member 5 may be an adhesive film. The first sealing member 51 may be a first adhesive film, and the second sealing member 52 may be a second adhesive film.

In some embodiments, the cover plate 3 and the back plate 8 may both be made of photovoltaic glass. The photovoltaic glass has better insulation and can meet higher system voltages. Moreover, the photovoltaic glass has good wear resistance, which prolongs the service life of the photovoltaic module.

As shown in FIG. 17, in some embodiments, the first sealing member 51 is located between the cover plate 3 and the half-cut solar cells 6, and a grammage of the first sealing member 51 is 360 g/mm² to 400 g/mm².

The grammage of the first sealing member 51 may be 360 g/mm², 370 g/mm², 380 g/mm², 390 g/mm², 400 g/mm², or the like. The first sealing member 51 may be made of polyethylene octene (POE). The POE film 5 has excellent anti-PID performance, high resistivity, a large water vapor barrier rate, and is resistant to low temperatures and yellowing. The use of the POE film 5 improves reliability of the photovoltaic module.

As shown in FIG. 17, in some embodiments, the second sealing member 52 is located between the half-cut solar cells 6 and the back plate 8, and a grammage of the second sealing member 52 is 400 g/mm² to 440 g/mm².

The grammage of the second sealing member 52 may be 400 g/mm², 410 g/mm², 420 g/mm², 430 g/mm², 440 g/mm², or the like. The second sealing member 52 may be made of ethylene-vinyl acetate (EVA). The EVA film 5 is easy to process, can be stored for a long time, has a fast cross-linking speed, and has good bonding performance with glass or the back plate 8, which facilitates manufacturing of the photovoltaic module. In addition, the EVA film 5 is less expensive, which reduces manufacturing costs of the photovoltaic module.

As shown in FIG. 15, in some embodiments, the photovoltaic module further includes wiring members 7. The wiring member 7 is configured to connect two adjacent half-cut solar cells 6. Along the thickness direction Z of the photovoltaic module, the half-cut solar cell 6 includes a first surface 45 and a second surface 46. The first surface 45 may be a front surface, and the second surface 46 may be a back surface. The wiring member 7 has one end connected to the first surface 45 of one half-cut solar cell 6 and another end connected to the second surface 46 of the adjacent half-cut solar cell 6.

The busbar electrodes 41 include positive busbar electrodes 41 and negative busbar electrodes 41. The positive busbar electrodes 41 and the negative busbar electrodes 41 are located on the first surface 45 and the second surface 46 of the half-cut solar cell 6, respectively. The wiring member 7 has one end connected to the positive busbar electrode 41 in one half-cut solar cell 6 and another end connected to the negative busbar electrode 41 in the adjacent half-cut solar cell 6. Therefore, in adjacent half-cut solar cells 6, the first surface 45 of one half-cut solar cell and the second surface 46 of the other half-cut solar cell are connected through the wiring member 7.

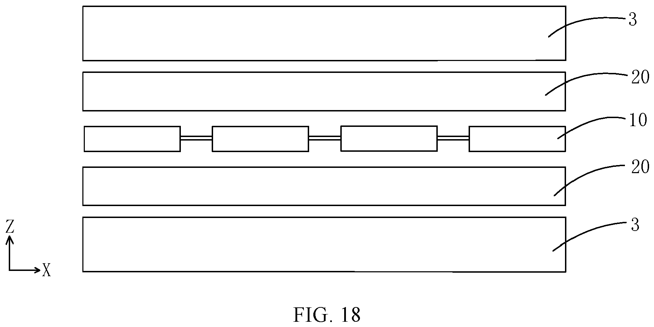

As shown in FIG. 18, some embodiments of the present disclosure further provide a photovoltaic module. The photovoltaic module includes at least one solar cell string 10. The solar cell string 10 is formed by electrically connecting a plurality of half-cut solar cells or one-third-cut solar cells of the solar cell 4 in any one of the above. Along a length direction X of the solar cell 4, a dimension L2 of the photovoltaic module satisfies 2380 mm≤L2≤2384 mm. Along a width direction Y of the solar cell 4, a dimension W2 of the photovoltaic module satisfies 2278 mm≤W2≤2384 mm.

The solar cell 4 may be cut into two half-cut solar cells or three one-third-cut solar cells. A plurality of half-cut solar cells or one-third-cut solar cells may be connected in series or in parallel to form the solar cell string 10. Since the solar cell 4 has a length L1 of 190 mm to 220 mm and a width W1 of 177 mm to 187 mm, the photovoltaic module may have a length L2 of 2380 mm to 2384 mm and a width W2 of 2278 mm to 2384 mm. For example, L2 may be 2380 mm, 2381 mm, 2382 mm, 2383 mm, or 2384 mm, or may be other values in the above range. W2 may be 2278 mm, 2280 mm, 2300 mm, 2310 mm, 2320 mm, 2330 mm, 2340 mm, 2350 mm, 2360 mm, 2370 mm, 2380 mm, or 2384 mm, or may be other values in the above range. For example, in the photovoltaic module, 6 solar cell strings 10 may be arranged along the width direction Y of the solar cell 4. In each solar cell string 10, 22 or 24 half-cut solar cells may be arranged along the length direction X of the solar cell 4. The photovoltaic module further includes an encapsulation layer 20 and a cover plate 3. Through a lamination process, the cover plate 3, the encapsulation layer 20, and the solar cell string 10 may be stacked in a certain order to obtain a laminated assembly, and then a frame (not shown in the figure) is mounted on the laminated assembly to form the photovoltaic module.

In some embodiments, 4 to 6 solar cells 4 are arranged in a row along a width direction Y of the photovoltaic module, and 8 to 14 solar cells 4 are arranged in a column along a length direction X of the photovoltaic module.

Through such a design, the solar cells 4 can form a cell array to absorb light and convert the light into electrical energy. Along the width direction Y of the photovoltaic module, a quantity of the solar cells 4 may be 4, 5, or 6. Along the length direction X of the photovoltaic module, a quantity of the solar cells 4 may be 8, 9, 10, 11, 12, 13, or 14.

In some embodiments, the solar cell 4 in the photovoltaic module adopts a half-cut structure, and the half-cut solar cell 6 is obtained from the solar cell 4. The solar cell 4 may be equally divided along a direction perpendicular to the length direction X of the solar cell 4 to obtain two half-cut solar cells 6. The half-cut solar cells 6 are symmetrical about a center line of the solar cell 4 along the width direction Y.

Compared with the structure directly using the entire solar cell 4, the photovoltaic module using the half-cut solar cells 6 has higher efficiency and is more in line with an actual usage requirement.

In some embodiments, 6 solar cells 4 are arranged in a row along the width direction Y of the photovoltaic module, and 11 to 12 solar cells 4 are arranged in a column along the length direction X of the photovoltaic module. That is, the photovoltaic module may include 66 solar cells 4 (132 half-cut solar cells 6) or the photovoltaic module may include 72 solar cells 4 (144 half-cut solar cells 6).

In some embodiments, the width of the photovoltaic module ranges from 1130 mm to 1138 mm, and the length of the photovoltaic module ranges from 2380 mm to 2384 mm.

This design can make transportation more convenient, improve space utilization of the container, reduce spare space of the container, help to improve transportation efficiency, reduce costs, and be more in line with an actual requirement.

The above descriptions are only preferred embodiments of the present disclosure, and are not intended to limit the present disclosure. For those skilled in the art, various modifications and changes may be made to the present disclosure. Any modifications, equivalent replacements, improvements, and the like made within the spirit and the principle of the present disclosure shall fall within the protection scope of the present disclosure.

## Claims

1. A method for manufacturing a silicon wafer, comprising:
providing (S0) a silicon ingot (1), wherein the silicon ingot has a circular cross section;
selecting (S1) four arc segments on a circumference of the silicon ingot (1) according to chamfering parameters of the silicon wafer;
squaring (S2) the silicon ingot along lines connecting adjacent arc segments to obtain a rectangular body having a rectangular cross-section shape with chamfers; and
cutting (S3) the rectangular body along a direction perpendicular to a length direction of the silicon ingot to obtain a rectangular silicon wafer (2) with chamfers.

2. The method for manufacturing a silicon wafer according to claim 1, wherein the selecting four arc segments on a circumference of the silicon ingot according to chamfering parameters of the silicon wafer comprises:
selecting (S11) four arc segments each having an arc length ranging from 0.5 mm to 6 mm on the circumference of the silicon ingot, wherein circle centers of the four arc segments coincide with a center of the cross section of the silicon ingot.

3. The method for manufacturing a silicon wafer according to claim 1, wherein the selecting four arc segments on a circumference of the silicon ingot according to chamfering parameters of the silicon wafer comprises:
selecting (S12) four arc segments each having a central angles ranging from 0.3° to 3° on the circumference of the silicon ingot, wherein circle centers of the four arc segments coincide with a center of the cross section of the silicon ingot.

4. The method for manufacturing a silicon wafer according to claim 1, wherein the rectangular silicon wafer with chamfers has a width ranging from 182 mm to 188 mm.

5. The method for manufacturing a silicon wafer according to claim 1, wherein the rectangular silicon wafer with chamfers has a length ranging from 180 mm to 220 mm.

6. The method for manufacturing a silicon wafer according to any one of claims 1 to 5, further comprising:
dividing (S4) the rectangular silicon wafer with chamfers into two symmetrical half-cut wafers along a straight line parallel to a width direction of the rectangular silicon wafer.

7. A solar cell (4), comprising: a silicon substrate (2), wherein the silicon substrate comprises four corners,
wherein the silicon substrate (2) further comprises four chamfer structures (43) at the four corners of the silicon substrate (2) respectively, each chamfer structure has an arc edge, and central angles of the arc edges of the four chamfer structures are equal, or
wherein the silicon substrate (2) further comprises two chamfer structures (43) at two corners of the four corners of the silicon substrate (2) respectively, the other two corners are right angles, each chamfer structure has an arc edge, and central angles of the arc edges of the two chamfer structures are equal.

8. The solar cell according to claim 7, wherein the solar cell has a length L1 ranging from 190 mm to 220 mm and a width W1 ranging from 177 mm to 187 mm, and the solar cell (2) further comprises N finger electrodes (42) that are arranged along a length direction of the solar cell, and the quantity N of the finger electrodes (42) satisfies 130≤N≤190;
wherein a central angle α corresponding to the arc edge of the chamfer structure satisfies 0.3°≤α≤3°.

9. The solar cell according to claim 8, wherein the length L1 of the solar cell satisfies 190 mm≤L1<200 mm, and the quantity N of the finger electrodes (42) satisfies 145≤N≤165.

10. The solar cell according to claim 8, wherein the length L1 of the solar cell satisfies 200 mm≤L1≤220 mm, and the quantity N of the finger electrodes (42) satisfies 160≤N≤180.

11. The solar cell according to any one of claims 8 to 10, wherein, along the length direction of the solar cell, a distance D1 between adjacent finger electrodes (42) satisfies: 1 mm≤D1≤3 mm.

12. The solar cell according to any one of claims 8 to 10, further comprising: M busbar electrodes (41), wherein the M busbar electrodes (41) are arranged along a width direction of the solar cell, the busbar electrodes intersect (41) with the finger electrodes (42) and are electrically connected to the finger electrodes (42), where the quantity M of the busbar electrodes (41) satisfies 16≤M≤20.

13. The solar cell according to claim 12, wherein, along the width direction of the solar cell, a distance D2 between adjacent busbar electrodes (41) satisfies 9 mm≤D2≤12 mm.

14. The solar cell according to claim 7, further comprising:
finger electrodes (41) extending along a width direction of the solar cell;
busbar electrodes (42) extending along the length direction of the solar cell; and
electrode pads (44),
wherein each busbar electrode (41) is connected to 5 to 10 electrode pads (44) of the electrode pads, the 5 to 10 electrode pads comprise a first electrode pad (441) and a second electrode pad (442), an area of the first electrode pad (441) satisfies 0.3 mm²≤S1≤0.6 mm², and an area of the second electrode pad (442) satisfies 0.8 mm²≤S2≤1.2 mm².

15. The solar cell according to claim 14, wherein the finger electrodes (42) are arranged with different pitches, or the busbar electrodes (41) are arranged with different pitches.
